Europäisches Patentamt

**European Patent Office**

Office européen des brevets

(19)

(11) Publication number: **0 199 585**
**B1**

(12) **EUROPEAN PATENT SPECIFICATION**

(45) Date of publication of the patent specification:
04.07.90

(51) Int. Cl.⁵: **C23C 16/48**

(21) Application number: **86303036.7**

(22) Date of filing: **22.04.86**

(54) **Apparatus for depositing electrically conductive and/or electrically insulating material on a workpiece.**

(30) Priority: **23.04.85 JP 87275/85**
**23.04.85 JP 87276/85**

(43) Date of publication of application:
**29.10.86 Bulletin 86/44**

(45) Publication of the grant of the patent:
**04.07.90 Bulletin 90/27**

(84) Designated Contracting States:
**DE FR GB NL**

(56) References cited:
**US-A- 4 457 803**

**EXTENDED ABSTRACTS OF THE 16th INTERNATIONAL
CONFERENCE ON SOLID STATE DEVICES AND
MATERIALS, Kobe, 30th August - 1st September 1984,
pages 31-34, Tokyo, JP; K. GAMO et al.:
"Characteristics of selective deposition of metal
organic films using focused ion beams" 000**

(73) Proprietor: **SEIKO INSTRUMENTS INC., 31-1,
Kameido 6-chome Koto-ku, Tokyo 136(JP)**

(72) Inventor: **Adachi, Tatsuya, 6-31-1, Kameido, Koto-ku
Tokyo(JP)**
Inventor: **Yamamoto, Masahiro, 6-31-1, Kameido,
Koto-ku Tokyo(JP)**

(74) Representative: **Miller, Joseph et al, J. MILLER & CO.
Lincoln House 296-302 High Holborn, London
WC1V 7JH(GB)**

## Description

The present invention relates to an apparatus for depositing electrically conductive and/or electrically insulating material on a workpiece.

Although the invention is not so restricted, it relates more particularly to an apparatus adapted to produce an electrically insulating film and an electrically conductive film successively on the surface of a specimen or workpiece, and to an apparatus for correcting a tiny circuit pattern such as a wiring pattern which comprises semiconductor elements by cutting the pattern into separate pattern portions and thereafter effecting an electrical connection between said pattern portions by forming a new electrically conductive pattern.

When two wiring pattern portions are to be electrically connected to each other in such a way as to extend across a very small wiring pattern (of the order of microns) after elements such as LSI's have been formed, it has been desirable to form a thin film of an electrically insulating material on the said small wiring pattern and to form an electrically conductive thin film on said thin insulating film so as to extend across the latter and thus accomplish the electrical connection between the two wiring pattern portions. It has also been desirable to form a thin electrically insulating film on a silicon substrate or on a thin electrically conductive film and to form an electrically conductive pattern on said thin insulating film, whereby to form tiny elements such as capacitors, microstrip lines and dielectric resonators at given places at given moments, or in order to adjust a variation in the characteristics of the element.

Moreover, when a variety of characteristics are to be measured for each of a number of blocks after elements such as LSI's have been formed, it may be desirable to cut wirings in order to separate each block from the other blocks. It may also be desirable to measure the characteristics of each of the elements or blocks independently from each other and, then, after electrically connecting the thus measured elements or blocks, to measure the total characteristics of the system as a whole. It may also be desirable to connect together those elements or blocks that exhibit good characteristics, in order to increase the manufacturing yields.

So far, however, it has not been easy to form a conductive pattern and an insulating pattern quickly at desired places at desired moments so as to provide alternate insulating and conductive layers after an LSI, a custom IC or other pattern has been completed, and it has been particularly difficult to maintain precision of the order of microns and especially of the order of submicrons.

Apparatus has previously been proposed to cut off portions (black defects) where excess of chromium adheres to a photomask, such cutting having been effected by using a laser beam. Apparatus has also previously been proposed to cause chromium to adhere to portions (white defects) that are missing in the photomask by using the laser beam in a gaseous atmosphere. When, however, such apparatus is used to effect direct cutting of a wiring pattern of the order of submicrons or to effect a direct connection in a wiring pattern of the order of submicrons, there is a limitation which is inevitably imposed on the minimum size that can be corrected due to the properties of light. Moreover, it is difficult to remove, for instance, a transparent film by using such apparatus.

In Extended Abstracts of the 16th International Conference on Solid State Devices and Materials, Kobe, 30th August - 1st September 1984, pages 31-34, Tokyo, Japan there is disclosed an apparatus for depositing electrically conductive or electrically insulating material on a workpiece comprising support means for supporting a workpiece, and means for directing an ion beam onto a surface region of a workpiece supported by said support means and for subjecting said surface region to a gas. In this citation, however, the gas is contained in an inner sample chamber and this involves the use of excessive quantities of gas, prevents rapid substitution of one gas for another, and, by virtue of making it difficult to control the supply of the gas, restricts the control of the deposition to control of the operation of the ion beam.

In US-A-4 457 803, moreover, there is disclosed a method and apparatus for effecting etching, e.g. of a semiconductor device, by means of a focused ion beam. No use, however, is made of a gas so that deposition of an electrically conductive or insulating material is not possible.

According, therefore, to the present invention, there is provided an apparatus for depositing electrically conductive and/or electrically insulating material on a workpiece comprising support means for supporting a workpiece and means for directing an ion beam onto a surface region of a workpiece supported by said support means and for subjecting said surface region to a gas so as to form electrically conductive and/or electrically insulating material thereon, characterised by a gas blowing device for blowing one or more gases onto said surface region while the latter is being irradiated with said ion beam, and a charged particle detector which detects data related to charged particles which are emitted from or are absorbed by the workpiece during the irradiation of said surface region by the ion beam, the operation of the gas blowing device being, in operation, controlled by the said detector in accordance with a predetermined program.

As will be appreciated, the use of a gas blowing device enables a substantial economy in the use of gas to be achieved, permits rapid substitution of one gas for another if so required, and improves the control over the deposition process by reason of providing a control over the operation of the gas blowing device.

Thus an apparatus according to the present invention may, if desired, be used easily and quickly to form a small conductive pattern and an insulating pattern in a laminated manner. It may also, if desired, be used to effect an electrical connection between pattern portions, making it possible to locally cut and then connect tiny patterns.

Preferably scanning means are provided for deflecting the ion beam so as to scan the said region.

Preferably the means for directing the ion beam onto the said surface region comprises means for focussing the ion beam thereon.

The apparatus preferably comprises a display device which is controlled by said detector so as to produce an image from said data.

The scanning means may be controlled by the said detector in accordance with a predetermined program.

Moreover, the gas blowing device may be selectively operable to blow onto said region either a gas for forming an electrically conductive pattern or a gas for forming an electrically insulating pattern.

In one embodiment, the means for directing the ion beam onto the said surface region is operable so that the ion beam cuts a portion of an electrically conductive pattern on the workpiece prior to operation of the gas blowing device.

The invention also comprises a method of depositing electrically conductive and/or electrically insulating material on a workpiece comprising supporting the workpiece on support means and directing an ion beam onto a surface region of the workpiece which is so supported while subjecting said surface region to a gas so as to form electrically conductive and/or electrically insulating material thereon, characterised in that one or more gases are blown onto the said surface region while the latter is being irradiated with said ion beam, and data relating to charged particles which are emitted from or absorbed by the workpiece during the irradiation of said surface region by the ion beam are detected and are used to control the gas blowing operation in accordance with a predetermined program.

Thus the gases may be such that at least one pair of alternate insulating and conductive films, or vice versa, are formed on the workpiece.

Preferably, a first gas is blown onto the said surface region while a first predetermined area of the region is being irradiated with a scanned focused ion beam to form a patterned insulating film on a wiring portion of a semiconductor device, and a second gas is blown onto the said surface region while a second predetermined area of the region is being irradiated with the scanned focused ion beam to form a conductive film which crosses the said patterned insulating film.

The arrangement may be such that, prior to the said blowing, the ion beam is directed onto a portion of an electrically conductive pattern on the workpiece so as to cut the latter into separate pattern portions, the said gas being such that the said separate pattern portions are electrically connected together by the said electrically conductive material which is formed on the said region as a result of the said blowing.

The invention is illustrated, merely by way of example, in the accompanying drawings, in which:-

Figure 1 is a diagrammatic view of a first embodiment of the present invention;

Figure 2 is a diagram illustrating the use of the embodiment of Figure 1;

Figure 3 is a diagrammatic view of a second embodiment of the present invention; and

Figures 4 and 5 are diagrams illustrating the use of the embodiment of Figure 3.

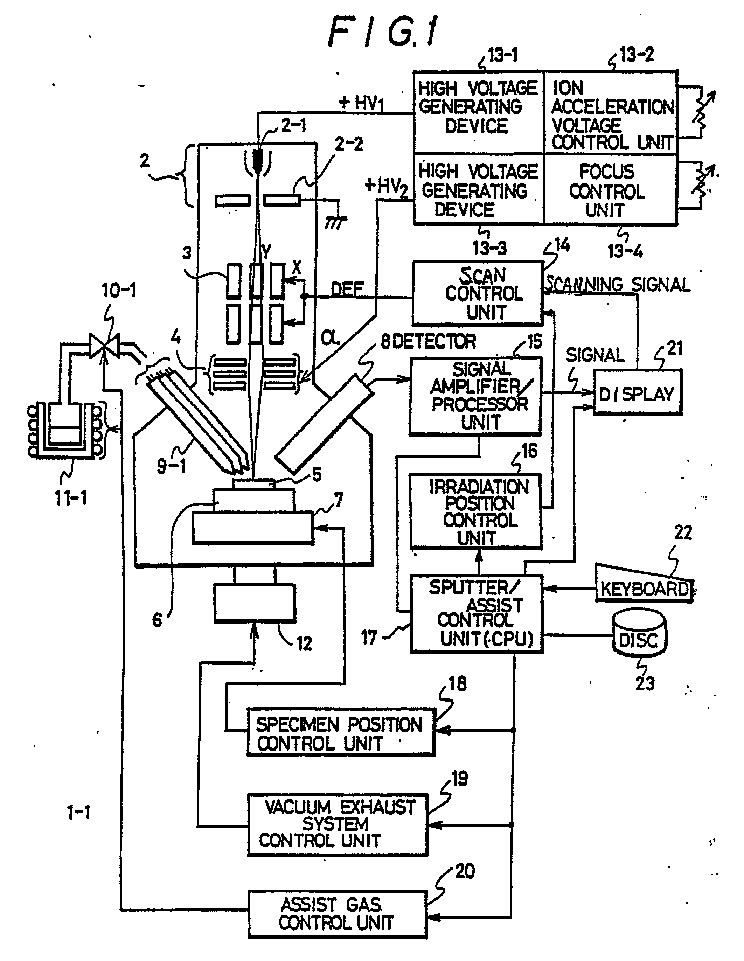

Referring to Figure 1, an apparatus 1-1 for depositing electrically conductive and/or electrically insulating material on a workpiece, e.g. an apparatus for forming and correcting electrical patterns, according to the present invention, comprises an ion gun 2. The ion gun 2 has an ion source 2-1 and an electrode 2-2. The apparatus also comprises deflecting electrodes (DEF) 3; an object glass or object lens (OL) 4; a specimen plate 6 for supporting a specimen or workpiece 5; a specimen moving mechanism 7; a charged particle detector 8 which detects data related to charged particles which are emitted from or are absorbed by the workpiece 5 during irradiation of the latter; a gas gun 9-1 for blowing assist gases; needle valves 10-1; gas sources 11-1; a vacuum exhaust device 12; high voltage generating devices 13-1, 13-3; an ion acceleration voltage control unit 13-2; a focus control unit 13-4; a scan control unit 14; a signal amplifier/processor unit 15; an irradiation position control unit 16; a sputter/assist control unit 17; a specimen position control unit 18; a vacuum exhaust system control unit 19; an assist gas control unit 20; a display 21 which is controlled by the detector 8 so as to produce an image from said data; a keyboard 22; and a disc 23.

The operation of the apparatus will first be described with reference to the case in which the charged particles such as secondary electrons which are emitted from the specimen that is irradiated with the ion beam are displayed as an SIM image on the display 21.

The ion gun 2 shown in Figure 1 receives a high voltage $+HV_1$ of positive polarity which is applied from the high voltage generating device 13-1 to the ion source 2-1. The latter may be needle-shaped with a sharp end and may contain gallium. The electrode 2-2 has a hole formed on the axis thereof and is grounded. The ion source 2-1 is heated to such a degree that liquid gallium forms at the end thereof, so that a beam of gallium ions is emitted. The acceleration voltage for accelerating the beam of gallium ions is set by the ion acceleration voltage control unit 13-2. The emitted beam of gallium ions is focussed or contracted (e.g. so that an image is formed) by the object lens (OL) 4 upon the specimen 5 mounted on the specimen plate 6, and is caused by X and Y electrodes of the deflecting electrodes 3 to scan the specimen 5. The secondary electrons emitted from the specimen 5 are detected by the detector 8, and are supplied to the signal amplifier/processor unit 15. A high voltage generated by the high voltage generating device 13-3 is applied to the object lens 4 responsive to a signal from the focus control unit 13-4, and a beam of gallium ions, which is contracted or focussed thereby, falls on the specimen 5. The signals supplied to the signal amplifier/processor unit 15 are amplified and processed, are supplied to the sputter/assist control unit 17, and are displayed on the display 21 as an SIM image. The magnification of the SIM image that is displayed on the display 21 is determined by the intensity of the scanning signals that are applied by the scan control unit 14 to the deflecting electrodes 3. The position of the specimen 5 observed on the display 21 is determined by the specimen moving mechanism 7 which moves the specimen plate 6 in response to instructions from the specimen position control unit 18, or which moves the specimen plate 6 via a manual mechanism that is not shown. The interior of the specimen chamber which constitutes the pattern forming and correcting device 1-1, and the region where the beam of gallium ions passes, are evacuated to a high degree of vacuum by the vacuum exhaust device 12 in response to an instruction from the vacuum exhaust system control unit 19.

Owing to the above-mentioned structure and operation, the SIM image of the specimen 5 can be observed, and the positions for laminating the conductive pattern and the insulating pattern can be correctly determined as will be described later.

The operation of the apparatus will now be described with reference to the case in which a conductive pattern and an insulating pattern are to be newly formed in a laminated manner.

As described above, the specimen plate 6 is so moved that the region which includes a pattern to be newly formed is displayed on the display 21 as an SIM image, and the focus of the object lens 4 is adjusted. The specimen plate 6 may be moved by storing in advance data such as position coordinates of the pattern on the LSI as a data base in the disc 23, and by inputting the position data and size of a pattern to be newly formed to the sputter/assist control unit 17 through the keyboard 22. Alternatively, the specimen plate 6 may be manually moved.

The data are then inputted from the keyboard 22 to the sputter/assist control unit 17, so that the beam of gallium ions will correctly scan, for a predetermined period of time, the region where a pattern is to be newly formed in the pattern that is displayed on the display 21. The sputter/assist control unit 17 gives an instruction to the irradiation position control unit 16 in response to the keyed input. The irradiation position control unit 16 which has received the instruction, sends a control signal to the scan control unit 14 so that a predetermined scanning voltage is applied to the deflecting electrodes 3.

In order to form a new conductive pattern or a new insulating pattern, furthermore, the sputter/assist control unit 17 sends an instruction to the assist gas control unit 20. A gas such as pyrene ($C_{16}H_{10}$) gas, which is generated by heating one of gas sources 11-1 and is provided to form, for example, a thin conductive film, is blown via the needle valves 10-1 and through any one of a plurality of nozzles constituting the gas gun 9-1 onto the specimen at the position at which the gallium ion beam is falling. The pyrene gas is decomposed by the gallium ion beam into electrically conductive carbon having a strong adhering force, and a film of this carbon is formed on the region that is scanned by the beam of gallium ions. Similarly, an $SiH_4$-$NH_3$ gas is blown from another nozzle of the gas gun 9-1 onto the surface of the specimen 5 which is irradiated with the beam of gallium ions, so that an electrically insulating silicon oxide ($SiO_2$) film is formed on the region that is scanned by the beam of gallium ions.

As described above, the electrically conductive pattern and the insulating pattern are successively formed in a laminated manner.

Needle valves 10-1 (the drawing shows only one needle valve) provided for each of the plurality of nozzles that constitute the gas gun 9-1 are closed when the assist gases are not supplied from the gas sources 11-1 to the plurality of nozzles that constitute the gas gun 9-1.

When a conductive pattern is to be formed, in general, the gas sources 11-1 are heated so as to supply, for example, the pyrene gas only as described above, and the gas generated from the gas sources 11-1 is blown through a predetermined nozzle of the gas gun 9-1 onto the surface of the specimen 5 that is irradiated with the beam of gallium ions. In order to blow the gas onto the surface of the specimen 5, in this case, a predetermined needle valve 10-1 only is opened. As required, furthermore, the needle valves 10-1 work to control the amount of gas supplied. As a gas for forming an electrically conductive pattern, furthermore, it is also allowable to blow a molybdenum compound gas, an aluminium compound gas or a chromium compound gas, instead of the pyrene gas, from a predetermined nozzle of the gas gun 9-1 onto the position on which the gallium ion beam is falling, in order to form a new conductive pattern of an electrically conductive substance while maintaining a size of the order of submicrons. By successively forming the conductive patterns and the insulating patterns in a laminating manner, the aforementioned elements such as capacitors, microstrip lines and the like can be formed at any places and at any moment.

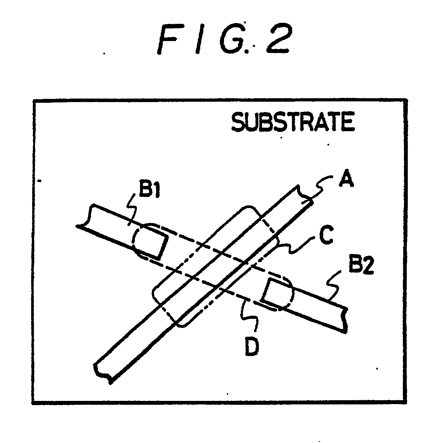

There will now be described in detail with reference to Figure 2 the operation which takes place when the electrically conductive pattern and the insulating pattern are formed in a laminated manner.

Figure 2 illustrates an example where an insulating pattern C and a conductive pattern D are formed to electrically connect a wiring pattern $B_1$ and a wiring pattern $B_2$, the conductive pattern D extending across a wiring pattern A which constitutes an LSI.

First, in order to form the insulating pattern C, as indicated by a two-dot chain line, on the wiring pattern A, a region for forming the insulating pattern C is displayed on the display 21 of Figure 1 in the way described above. Data are inputted from the keyboard 22 to the sputter/assist control unit 17, the said data being input data related to the region for forming the insulating pattern C, data related to the assist gas, i.e. for specifying the gas to form the insulating pattern C, and data related to the thickness of film of the insulating pattern C. Therefore, the sputter/assist control unit 17 sends an instruction to the irradiation position control unit 16 and to the assist gas control unit 20 as described above, to so control the scanning signals that the gallium ion beam scans the region where the above specified insulating pattern C will be formed, and that $SiH_4$-$NH_3$ gas for forming the insulating pattern C will be blown onto a position where the gallium ion beam is falling. As a result of the gallium ion beam being irradiated for a predetermined period of time, the insulating pattern C will be formed with a predetermined film thickness.

Secondly, the electrically conductive pattern D indicated by a dotted line is formed to electrically connect the wiring pattern $B_1$ and the wiring pattern $B_2$ together in such a way as to cross over the insulating pattern C that was formed in the first step. As in the case of the first step, data related to assist gas for specifying the gas that forms the conductive pattern C and data related to the film thickness of the conductive pattern are inputted from the keyboard 22. As described above,therefore, the sputter/assist control unit 17 sends an instruction to the irradiation position control unit 16 and to the assist gas control unit 20 to so control the scanning signals that the gallium ion beam will scan the region where the above specified conductive pattern D is to be formed, and that the pyrene gas for forming the conductive pattern D will be blown onto a position where the gallium ion beam is falling. After being irradiated with the gallium ion beam for a predetermined period of time, the conductive pattern D will be formed with a predetermined film thickness.

By means of the conductive pattern D which has been formed on the insulating pattern C so as to cross over the latter as described above, it is possible to electrically connect the wiring pattern $B_1$ and the wiring pattern $B_2$ by means of a connection having a size of the order of submicrons. Thus this connection may be easily and quickly formed so as to extend across the wiring pattern A which may itself be an LSI that has been completed already.

Further, by forming an insulating pattern on the conductive pattern in the same manner as mentioned above and by further forming a conductive pattern on the insulating pattern in a laminated manner, a capacitor can be formed at any place, at any moment, and in any size of the order of submicrons. It is easy to repair the wiring patterns that are formed in sizes of the order of microns or often in the order of submicrons, or to disconnect a defective element and connect another spare element. For example, when wiring patterns for driving a liquid crystal panel, the wiring patterns being arranged in the form of dots used as a display, are to be repaired, or when a defective drive element is to be disconnected from the wiring pattern and another spare drive element is to be connected, the electrical connection can be accomplished in a manner so as to extend over other wirings.

Thus, as described above with reference to Figures 1 and 2, means are employed to successively blow gas that forms a conductive film and a gas that forms an insulating film, or vice versa, onto the surface of the specimen while it is being irradiated with an ion beam, making it possible to form a very small pattern having alternate layers consisting of an electrically conductive pattern layer and an insulating pattern layer. In particular, it is made possible to effect an electrical connection between wiring patterns, which connection extends across a wiring pattern that has been completed already, such as an LSI, the said electrical connection having a size of the order of microns and often of the order of submicrons. Furthermore, it is possible to form a very small capacitor at any moment, at any place, and in any size of the order of microns.

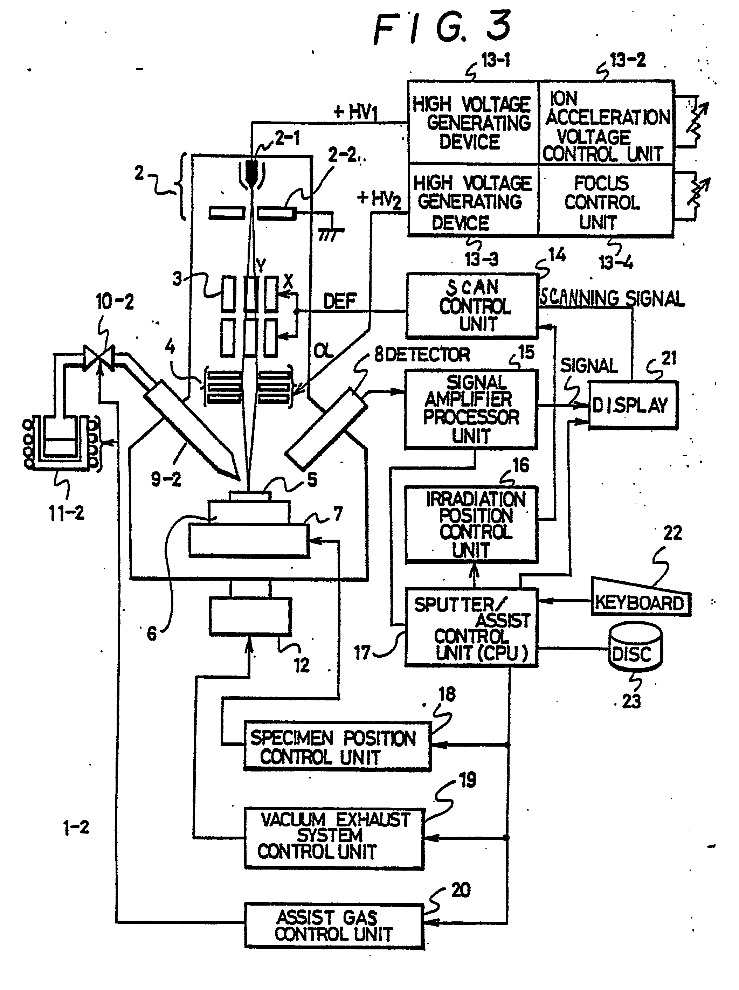

Another embodiment of the present invention will now be described in detail with reference to Figures 3-5.

Referring to Figure 3, an apparatus 1-2 for forming or correcting electrical patterns, especially for correcting them, according to the present invention, comprises a gas gun 9-2 for blowing an assist gas, a needle valve 10-2, and a gas source 11-2. The other parts of the construction of Figure 3 correspond to the like parts of Figure 1 and are given the same reference numerals.

Reference will first be made to a first mode of operation in which the charged particles such as secondary electrons emitted from the specimen or workpiece 5 that is irradiated with the ion beam are displayed as an SIM image on the display 21.

In the ion gun 2 shown in Figure 3, a high voltage $+HV_1$ of positive polarity is applied from the high voltage generating device 13-1 to the ion source 2-1. The latter may be needle-shaped with a sharp end and may contain gallium. The ion gun 2 has an electrode 2-2 that has a hole formed on the axis thereof and is grounded. The ion source 2-1 is heated to a temperature such that liquid gallium forms at the end thereof, so that a beam of gallium ions is emitted. The acceleration voltage for accelerating the beam of gallium ions is set by the ion acceleration voltage control unit 13-2. The emitted beam of gallium ions is contracted by the object lens (OL) 4 or is focussed thereby so as to form an image on the specimen 5 mounted on the specimen plate 6. The ion beam is caused by the X and Y electrodes of the deflecting electrodes 3 to scan the specimen 5. The secondary electrons emitted from the specimen 5 are detected by the detector 8, and are supplied to the signal amplifier unit 15. A high voltage generated by the high voltage generating device 13-3 is applied to the object lens 4 in response to a signal from the focus control unit 13-4, and a beam of gallium ions, which is contracted or focussed thereby, falls on the specimen 5. The signals supplied to the signal amplifier/processor unit 15 are amplified and processed, and are displayed on the display 21 as an SIM image. The magnification of the SIM image that is displayed is determined by the intensity of scanning signals that are applied by the scan control unit 14 to the deflecting electrodes 3. The position of the specimen 5 observed on the display 21 is determined by the specimen moving mechanism 7 which either moves the specimen plate 6 in response to an instruction from the specimen position control unit 18, or which moves the specimen plate 6 via a manual mechanism that is not shown. The interior of the specimen chamber which constitutes the apparatus or pattern correcting device 1-2, and the region where the beam of gallium ions passes, are evacuated to a high degree of vacuum by the vacuum exhaust device 12 in response to an instruction from the vacuum exhaust system control unit 19.

In the apparatus of Figure 3, the SIM image of the specimen 5 can thus be observed, and the positions for cutting and connecting the pattern can be determined as will be described later.

There is now described below a second mode of operation in which the pattern is to be cut by sputtering.

As described above, the specimen plate 6 is so moved that the pattern to be cut is displayed as an SIM image on the display 21, and the focus of the object lens 4 is adjusted. The specimen plate 6 may be moved by storing in advance the position coordinates and sizes of the pattern such as an LSI as a data base in the disc 23, and by inputting the position data to be cut to the sputter/assist control unit 17 through the keyboard 22. Alternatively, the specimen plate 6 may be manually moved. The sputter/assist control unit 17 gives instructions to the irradiation position control unit 16 in response to the keyed input from the keyboard 22, such that the beam of gallium ions correctly scans the region that is to be cut in the pattern displayed on the display 21 for a predetermined period of time so as to sputter (cut) it. The irradiation position control unit 16, which has received the instruction, sends a control signal to the scan control unit 14 so that a predetermined scanning voltage is applied to the deflecting electrodes 3. The pattern of the region is irradiated with the beam of gallium ions continuously for a predetermined period of time and is gradually sputtered with ions and is finally cut.

There will now be described a third mode of operation in which a new electrically conductive pattern is to be formed after the original pattern has been cut as described above.

The specimen plate 6 is so moved that the SIM image, which includes the region where a new conductive pattern to be formed is located, is displayed on the display 21 in the manner mentioned above, and the object lens 4 adjusts the focus. In response to the data base related to the position coordinates and the sizes of the pattern that have been stored in the disc 23 in advance, the positions and sizes of a conductive pattern that is to be newly formed are inputted to the sputter/assist control unit 17 through the keyboard 22. The sputter/assist control unit 17 gives instruction to the irradiation position control unit 16 such that a region corresponding to the pattern that is to be newly formed in the image displayed on the display 21 is correctly scanned by the gallium ion beam for a predetermined period of time. The irradiation position control unit 16 which has received the instruction sends a control signal to the scan control unit 14 so that a predetermined scanning voltage is applied to the deflecting electrodes 3. Unlike the case where the pattern was sputtered, the sputter/assist control unit 17 also sends an instruction to the assist gas control unit 20 in order to form a new electrically conductive pattern. A gas such as pyrene ($C_{16}H_{10}$) generated by heating the gas source 11-2 is blown from the gas gun 9-2 through the needle valve 10-2 onto the specimen 5 at the position where the gallium ion beam is falling. The pyrene gas is decomposed by the gallium ion beam into electrically conductive carbon having a strong adhering force, which is then formed as a new electrically conductive pattern at the region that was scanned with the gallium ion beam.

The needle valve 10-2 is closed when the assist gas is not supplied from the gas source 11-2 to the gas gun 9-2 (e.g. as in the first and second modes). As required, furthermore, the needle valve 10-2 is used to control the amount of the gas that is supplied. It is also possible to blow a molybdenum compound gas, an aluminium compound gas or a chromium compound gas, instead of the pyrene gas, from the gas gun 9-2 onto the position where the gallium ion beam is falling, in order to form a new conductive pattern of an electrically conductive substance, to effect electrical connection between the pattern portions while maintaining pattern sizes of the order of submicrons.

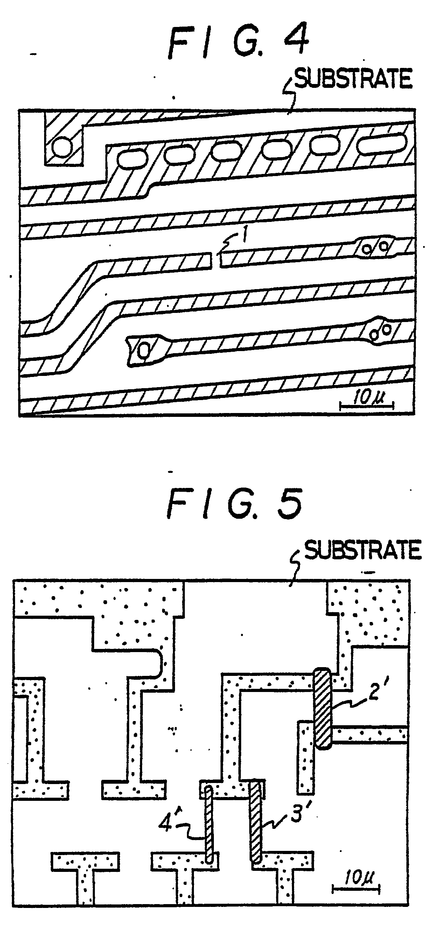

Figure 4 shows an SEM image (secondary electron image) in which a pattern of the LSI is cut at a portion designated at 1. The LSI shown in Figure 4 includes a conductive wiring pattern as indicated by hatched lines which is covered with a passivation film (protection film) having a thickness of several thousand angstroms. That is to say, Figure 4 shows a pattern formed by tracing the secondary electron image (SEM image) obtained by irradiating the passivation film with an electron ray. Therefore, a portion of the pattern designated at 1 is cut by sputtering the passivation film with the gallium ion beam and then sputtering said pattern. By sputtering the specimen 5 with a beam of heavy ions such as gallium ions, a tiny pattern covered with the passivation film can be easily cut.

Figure 5 shows an SEM image in which patterns constituting the LSI are electrically connected together using electrically conductive patterns that are newly formed in shapes as designated at 2', 3', 4'. The patterns 2', 3', 4' indicated by hatched lines are comprised of, for example, electrically conductive carbon films formed by decomposing the assist gas by blowing the assist gas (e.g. the pyrene gas mentioned earlier) onto the regions that are to be connected while these regions are being irradiated with the gallium ion beam. By blowing the assist gas while irradiating the regions with a beam of heavy ions such as gallium ions, tiny electrically conductive patterns can be newly and easily formed on the surface of the specimen 5 to accomplish the electric connection.

In the embodiment illustrated in Figures 3 to 5, the pattern is directly cut by the irradiation with the ion beam, and a gas is thereafter blown while the pattern is being irradiated with the ion beam to form a new electrically conductive pattern. Therefore, the pattern portions which have been cut can be electrically connected directly, making it easy to cut tiny patterns locally and to accomplish their subsequent electric connection. In particular, the invention makes it possible to cut the pattern locally and to accomplish the electric connection even in regions of sizes of the order of submicrons that are beyond the limit which is imposed when light such as laser beam is used.

## Claims

1. An apparatus for depositing electrically conductive and/or electrically insulating material on a workpiece (5) comprising support means (6) for supporting a workpiece (5) and means (2, 4) for directing an ion beam onto a surface region of a workpiece (5) supported by said support means (6) and for subjecting said surface region to a gas so as to form electrically conductive and/or electrically insulating material thereon, characterised by a gas blowing device (9-1, 9-2) for blowing one or more gases onto said surface region while the latter is being irradiated with said ion beam, and a charged particle detector (8) which detects data related to charged particles which are emitted from or are absorbed by the workpiece (5) during the irradiation of said surface region by the ion beam, the operation of the gas blowing device (9-1, 9-2) being, in operation, controlled by the said detector (8) in accordance with a predetermined program.

2. An apparatus as claimed in claim 1 characterised in that scanning means (3) are provided for deflecting the ion beam so as to scan the said region.

3. An apparatus as claimed in claim 1 or 2 characterised in that the means (2, 4) for directing the ion beam onto the said surface region comprises means (4) for focussing the ion beam thereon.

4. An apparatus as claimed in any preceding claim characterised by a display device (21) which is controlled by said detector (8) so as to produce an image from said data.

5. An apparatus as claimed in claim 2 characterised in that the scanning means (3) are controlled by the said detector (8) in accordance with a predetermined program.

6. An apparatus as claimed in any preceding claim characterised in that the gas blowing device (9-1) is selectively operable to blow onto said region either a gas for forming an electrically conductive pattern or a gas for forming an electrically insulating pattern.

7. An apparatus as claimed in any preceding claim characterised in that the means (2, 4) for directing the ion beam onto the said surface region is operable so that the ion beam cuts a portion of an electrically conductive pattern on the workpiece (5) prior to operation of the gas blowing device (9-2).

8. A method of depositing electrically conductive and/or electrically insulating material on a workpiece (5) comprising supporting the workpiece (5) on support means (6) and directing an ion beam onto a surface region of the workpiece (5) which is so supported while subjecting said surface region to a gas so as to form electrically conductive and/or electrically insulating material thereon, characterised in that one or more gases are blown onto the said surface region while the latter is being irradiated with said ion beam, and data relating to charged particles which are emitted from or absorbed by the workpiece (5) during the irradiation of said surface region by the ion beam are detected and are used to control the gas blowing operation in accordance with a predetermined program.

9. A method as claimed in claim 8 characterised in that the gases are such that at least one pair of alternate insulating and conductive films, or vice versa, are formed on the workpiece (5).

10. A method as claimed in claim 9 characterised in that a first gas is blown onto the said surface region while a first predetermined area of the region is being irradiated with a scanned focused ion beam to form a patterned insulating film on a wiring portion of a semiconductor device, and a second gas is blown onto the said surface region while a second predetermined area of the region is being irradiated with the scanned focused ion beam to form a conductive film which crosses the said patterned insulating film.

11. A method as claimed in any of claims 8-10 characterised in that, prior to the said blowing, the ion beam is directed onto a portion of an electrically conductive pattern on the workpiece (5) so as to cut the latter into separated pattern portions, the said gas being such that the said separate pattern portions are electrically connected together by the said electrically conductive material which is formed on the said region as a result of the said blowing.

**Patentansprüche**

1. Vorrichtung zur Abscheidung eines elektrisch leitenden und/oder nichtleitenden Materials auf einem Werkstück (5), die eine Halteeinrichtung (6) zum Halten eines Werkstückes (5) und eine Einrichtung (2, 4) zum Lenken eines Ionenstrahls auf einen Flächenbereich eines Werkstückes (5) aufweist, das von der Halteeinrichtung (6) gehalten wird, sowie zum Beaufschlagen des Flächenbereichs mit einem Gas, so daß elektrisch leitendes und/oder elektrisch nichtleitendes Material darauf gebildet wird, gekennzeichnet durch eine Gasblaseinrichtung (9-1, 9-2) zum Blasen eines oder mehrerer Gase auf den Flächenbereich, während der letztgenannte mit dem Ionenstrahl bestrahlt wird und ein Ladungsteilchendetektor (8), der Daten betreffend die geladenen Teilchen feststellt, die von dem Werkstück (5) während der Bestrahlung des Flächenbereiches mit dem Ionenstrahl abgegeben oder absorbiert werden, wobei der Betrieb der Gasblaseinrichtung (9-1, 9-2) beim Betreiben durch den Detektor (8) nach Maßgabe eines vorbestimmten Programms gesteuert wird.

2. Vorrichtung nach Anspruch 1, dadurch gekennzeichnet, daß Abtasteinrichtungen (3) zum Ablenken des Ionenstrahls vorgesehen sind, um den Bereich abzutasten.

3. Vorrichtung nach Anspruch 1 oder 2, dadurch gekennzeichnet, daß die Einrichtung (2, 4) zum Lenken des Ionenstrahls auf den Flächenbereich eine Einrichtung (4) zum Fokussieren des Ionenstrahls auf dieselbe aufweist.

4. Vorrichtung nach einem der vorangehenden Ansprüche, gekennzeichnet durch eine Anzeigeeinrichtung (21), die durch den Detektor (8) derart gesteuert wird, daß ein Bild von den Daten erzeugt wird.

5. Vorrichtung nach Anspruch 2, dadurch gekennzeichnet, daß die Abtasteinrichtungen (3) durch den Detektor (8) nach Maßgabe eines vorbestimmten Programms gesteuert werden.

6. Vorrichtung nach einem der vorangehenden Ansprüche, dadurch gekennzeichnet, daß die Gasblaseinrichtung (9-1) selektiv derart betreibbar ist, daß auf den Bereich entweder ein Gas zur Bildung eines elektrisch leitenden Musters oder ein Gas zur Bildung eines elektrisch nichtleitenden Musters geblasen wird.

7. Vorrichtung nach einem der vorangehenden Ansprüche, dadurch gekennzeichnet, daß die Einrichtung (2, 4) zum Lenken des Ionenstrahls auf diesen Flächenbereich derart betreibbar ist, daß der Ionenstrahl ein Teil eines elektrisch leitenden Musters auf dem Werkstück (5) vor dem Arbeiten der Gasblaseinrichtung (9-2) ausschneidet.

8. Verfahren zur Abscheidung eines elektrisch leitenden und/oder elektrisch nichtleitenden Materials auf einem Werkstück (5), bei dem das Werkstück (5) auf einer Halteeinrichtung (6) abgestützt wird und ein Ionenstrahl auf einen Flächenbereich des Werkstückes (5) gerichtet wird, welches gehalten ist und bei dem zugleich der Flächenbereich mit einem Gas derart beaufschlagt wird, daß sich an demselben ein elektrisch leitendes und/oder elektrisch nichtleitendes Material bildet, dadurch gekennzeichnet, daß ein oder mehrere Gase auf den Flächenbereich geblasen werden, während der letztgenannte mit dem Ionenstrahl bestrahlt wird, und daß Daten betreffend die Ladungsteilchen, die von dem Werkstück (5) während der Bestrahlung des Flächenbereiches durch den Ionenstrahl abgegeben oder absorbiert werden, erfaßt werden und diese zur Steuerung des Gasblasvorganges nach Maßgabe eines vorbestimmten Programms genutzt werden.

9. Verfahren nach Anspruch 8, dadurch gekennzeichnet, daß die Gase derart gewählt sind, daß wenigstens ein Paar von abwechselnden, nichtleitenden und leitenden dünnen Schichten oder umgekehrt auf dem Werkstück (5) gebildet werden.

10. Verfahren nach Anspruch 9, dadurch gekennzeichnet, daß ein erstes Gas auf den Flächenbereich geblasen wird, während eine erste vorbestimmte Zone des Bereichs mit einem fokussierten Abtastionenstrahl bestrahlt wird, um einen gemusterten, nichtleitenden Film auf einem Leitungsabschnitt einer Halbleitereinrichtung zu bilden, und daß ein zweites Gas auf den Flächenbereich geblasen wird, während eine zweite vorbestimmte Zone des Bereichs mit dem fokussierten Abtastionenstrahl bestrahlt wird, um einen leitenden Film zu bilden, welcher den als Muster vorgesehenen, nichtleitenden Film kreuzt.

11. Verfahren nach einem der Ansprüche 8 bis 10, dadurch gekennzeichnet, daß vor dem Blasen der Ionenstrahl auf einen Abschnitt eines elektrisch leitenden Musters auf dem Werkstück (5) derart gerichtet wird, daß das letztgenannte in gesonderte Musterabschnitte getrennt wird und daß das Gas derart gewählt wird, daß die gesonderten Musterabschnitte über das elektrisch leitende Material elektrisch miteinander verbunden sind, das auf dem Bereich als Ergebnis des Blasens gebildet wird.

## Revendications

1. Un appareil pour déposer un matériau électriquement conducteur et/ou électriquement isolant sur une pièce (5), comprenant des moyens de support (6) pour supporter une pièce (5) et des moyens (2, 4) pour diriger un faisceau d'ions sur une région de surface d'une pièce (5) qui est supportée par les moyens de support (6), et pour soumettre cette région de surface à l'action d'un gaz, de façon à former sur elle un matériau électriquement conducteur et/ou électriquement isolant, caractérisé par un dispositif de soufflage de gaz (9-1, 9-2) destiné à souffler un ou plusieurs gaz sur la région de surface précitée, pendant que cette dernière est irradiée avec le faisceau d'ions, et un détecteur de particules chargées (8) qui détecte des données concernant des particules chargées qui sont émises ou absorbées par la pièce (5) pendant l'irradiation de la région de surface précitée par le faisceau d'ions, le fonctionnement du dispositif de soufflage de gaz (9-1, 9-2) étant commandé par le détecteur (8), conformément à un programme prédéterminé.

2. Un appareil selon la revendication 1, caractérisé en ce que des moyens de balayage (3) sont incorporés pour dévier le faisceau d'ions de façon à balayer la région précitée.

3. Un appareil selon la revendication 1 ou 2, caractérisé en ce que les moyens (2, 4) qui sont destinés à diriger le faisceau d'ions sur la région de surface précitée comprennent des moyens (4) pour focaliser le faisceau d'ions sur cette surface.

4. Un appareil selon l'une quelconque des revendications précédentes, caractérisé par un dispositif de visualisation (21) qui est commandé par le détecteur (8), de façon à produire une image à partir des données précitées.

5. Un appareil selon la revendication 2, caractérisé en ce que les moyens de balayage (3) sont commandés par le détecteur (8) conformément à un programme prédéterminé.

6. Un appareil selon l'une quelconque des revendications précédentes, caractérisé en ce qu'on peut faire fonctionner sélectivement le dispositif de soufflage de gaz (9-1) pour souffler sur la région précitée soit un gaz pour former un motif électriquement conducteur, soit un gaz pour former un motif électriquement isolant.

7. Un appareil selon l'une quelconque des revendications précédentes, caractérisé en ce qu'on peut faire fonctionner les moyens (2, 4) pour diriger le faisceau d'ions sur la région de surface précitée, de façon que le faisceau d'ions coupe une partie d'un motif conducteur de l'électricité sur la pièce (5), avant le fonctionnement du dispositif de soufflage de gaz (9-2).

8. Un procédé pour déposer un matériau électriquement conducteur et/ou électriquement isolant sur une pièce (5), dans lequel on supporte la pièce (5) sur des moyens de support (6) et on dirige un faisceau d'ions sur une région de surface de la pièce (5) qui est ainsi supportée, tout en soumettant cette région de surface à l'action d'un gaz, afin de former sur elle un matériau électriquement conducteur et/ou électriquement isolant, caractérisé en ce qu'on souffle un ou plusieurs gaz sur la région de surface précitée, pendant que cette dernière est irradiée avec le faisceau d'ions, et on détecte des données concernant des particules chargées qui sont émises ou absorbées par la pièce (5), pendant l'irradiation de la région de surface précitée par le faisceau d'ions, et on utilise ces données pour commander l'opération de soufflage de gaz conformément à un programme prédéterminé.

9. Un procédé selon la revendication 8, caractérisé en ce que les gaz sont tels qu'au moins une paire de pellicules isolante et conductrice alternées, ou inversement, sont formées sur la pièce (5).

10. Un procédé selon la revendication 9, caractérisé en ce qu'on souffle un premier gaz sur la région de surface précitée pendant qu'une première zone prédéterminée de la région est irradiée avec un faisceau d'ions focalisé et soumis à un mouvement de balayage, pour former une pellicule isolante définissant un motif sur une partie d'interconnexion d'un dispositif à semiconducteurs, et on souffle un second gaz sur la région de surface précitée pendant qu'une seconde zone prédéterminée de la région est irradiée avec le faisceau d'ions focalisé et soumis à un mouvement de balayage, pour former une pellicule conductrice qui croise la pellicule isolante définissant un motif.

11. Un procédé selon l'une quelconque des revendications 8 à 10, caractérisé en ce que, avant l'opération de soufflage, on dirige le faisceau d'ions sur une partie d'un motif électriquement conducteur formé sur la pièce (5), afin de couper ce dernier pour donner des parties de motif séparées, le gaz étant tel que les parties de motif séparées sont connectées électriquement ensemble par le matériau conducteur de l'électricité qui est formé sur la région précitée, sous l'effet de l'opération de soufflage.

# F I G.1

# F I G. 2

# F I G. 3

EP 0 199 585 B1

## F I G. 4

SUBSTRATE

10 μ

## F I G. 5

SUBSTRATE

2'

4' 3'

10 μ